# NEUE EUROPÄISCHE PATENTSCHRIFT

(11) **EP 0 339 306 B2**
(45) Veröffentlichungstag und Bekanntmachung des Hinweises auf die Entscheidung über den Einspruch: **06.10.1999**
(45) Hinweis auf die Patenterteilung: 10.02.1993
(21) Anmeldenummer: 89105856.2
(22) Anmeldetag: 04.04.1989
(51) Int. Cl.: G03F 7/033

(54) **Verwendung eines lichtempfindlichen Gemischs mit Carboxylgruppen enthaltenden Bindemitteln zur Bildaufzeichnung**
Use of a lightsensitive composition with binders containing carboxyl groups in image recording
Utilisation d'une composition sensible à la lumière avec des liants contenant des groupes carboxyliques dans un procédé d'enregistrement d'une image

(30) Priorität: 29.04.1988 DE 3814567
(43) Veröffentlichungstag der Anmeldung: 02.11.1989
(73) Patentinhaber: E.I. DU PONT DE NEMOURS AND COMPANY, Wilmington Delaware 19898 (US)
(72) Erfinder: Sondergeld, Manfred, Dr., D-6052 Mühlheim/Main (DE); Goodin, Jonathan, Dr., D-6078 Neu-Isenburg (DE)
(74) Vertreter: Pistor, Wolfgang, Dr. Dipl.-Chem.

(56) Entgegenhaltungen:
- EP-A- 0 183 552
- DE-A- 2 512 693
- FR-A- 2 350 625
- GB-A- 2 102 138
- JP-A- 52 132 091
- US-A- 3 998 907
- J.Kosar " Light-Sensitive Systems ", Wiley, New York, 1965, Seite 103
- Ullmanns Encyklopädie der technischen Chemie, 4. Auflage, Band 20, 1981, Seite 167
- Römpp Chemie Lexikon, 9. Auflage, 1991, Seiten 3098, 3099 und 3417

## Beschreibung

Die Erfindung betrifft ein lichtempfindliches Gemisch, mit mindestens einer additionspolymerisierbaren, ethylenisch ungesättigten Verbindung, einem Photoinitiator oder einem Photoinitiatorsystem und mindestens einem polymeren Bindemittel, das ein Copolymer-mit jeweils einer oder mehreren unterschiedlichen Struktureinheiten A und B und mindestens einer weiteren, carboxylgruppenhaltigen Struktureinheit ist. Lichtempfindliche Gemische finden vielfach Verwendung in Bildaufzeichnungsmaterialien, insbesondere bei der Herstellung von Photoresists, Lötstopmasken und Druckplatten.

Photopolymerisierbare Resistmaterialien sind z.B. bekannt aus den US-Patentschriften US 3,469,982 und US 3,547,730, welche ein Filmresist mit einer Sandwichstruktur beschreiben in Form einer photopolymerisierbaren Schicht zwischen einer Deckschicht und einem temporären Träger. Dieser Filmresist kann z.B. auf eine Kupferunterlage laminiert, bildmäßig belichtet und entwickelt werden, wodurch eine Resistschicht gebildet wird.

Die so hergestellte Resistschicht erlaubt nun ein selektives Ätzen, Galvanisieren oder Löten auf dem Substrat. Besonders hohe Anforderungen werden an Photoresistfilme gestellt, wenn sie als Lötstopmaske benutzt werden. Die entwickelte, photopolymerisierte Schicht muß hierbei Temperaturen bis 300°C überstehen. Nach dem Stand der Technik können solche Lötstopmasken durch Spritzen, Gießen oder Drucken von flüssigen Gemischen auf ein Substrat oder auch durch Laminieren eines Trockenfilms auf ein Substrat hergestellt werden.

Die beschriebenen Photoresistfilme bestehen üblicherweise aus einem temporären oder permanenten Träger, einer photopolymerisierbaren Schicht, die ein polymeres Bindemittel, additionspolymerisierbare Verbindungen und einen Photoinitiator enthält, und einer Deckschicht. Nachdem, ggf. nach dem Laminieren auf ein Substrat, die bildmäßige Belichtung erfolgt ist, kann die Deckschicht entfernt und die photopolymerisierte Schicht entwickelt werden. Manche photopolymerisierbaren Gemische sind mit organischen Lösungsmitteln entwickelbar, manche mit wäßrigen Lösungen.

Häufig enthalten die polymeren Bindemittel solcher photopolymerisierbarer Bildaufzeichnungsmaterialien, insbesondere solcher, die wäßrig entwickelbar sind, Säurefunktionen, vor allem Carboxylfunktionen. Diese Gruppen sind jedoch in vielen weiteren Verarbeitungsschritten nachteilig. Im Falle von Photoresists beobachtet man z.B. beim alkalischen Ätzen oder Goldplating ein Ablösen der Resists, im Falle von Lötstopmasken mangelnde Feuchtigkeits- und Isolationseigenschaften.

Besonders vollständig wäßrig verarbeitbare Photopolymersysteme mit hohen Auswaschraten und u.U. schnellem Strippverhalten zeigen aufgrund ihrer hydrophilen Eigenschaften Schwächen in anderen Prozeßschritten, z.B. geringe Entwicklungsbreite, Strippen beim alkalischen Ätzen und beim Goldplating oder mangelnde Klimabeständigkeit.

Auf dem Gebiet der Photoresists ist die Modifizierung der Carboxylgruppen mit Melaminverbindungen zur Überwindung der genannten Nachteile bekannt (EP 01 15 354 und US 4,247,621). Durch den Zusatz der Melaminverbindungen kann aber die Lichtempfindlichkeit der photopolymerisierbaren Gemische verringert werden, so daß solche Gemische längere Belichtungszeiten erfordern. Weiterhin neigen manche dieser Verbindungen bei längerer Lagerung der photopolymerisierbaren Massen zur Kristallisation, was dann zur Unbrauchbarkeit der damit hergestellten Aufzeichnungsmaterialien führt.

Aus der DE 33 29 443 sind lichtempfindliche Gemische bekannt, die Bindemittel mit hydroxy-, alkoxy- oder acyloxysubstituierten Säureamidgruppen enthalten. Obwohl durch eine Reaktion dieser sauerstoffhaltigen Gruppen mit Hydroxy- oder Carboxygruppen in demselben oder in einem weiteren Bindemittel eine teilweise Vernetzung der Bindemittel erfolgen kann, werden auch diesen lichtempfindlichen Gemischen, vor allem bei ihrer Verwendung in Lötstopmasken, Melaminverbindungen zugesetzt. Diese weisen aber die schon geschilderten Nachteile auf. Die JP-A-52 132 091 beschreibt lichtempfindliche Gemische, insbesondere zur Herstellung von Druckplatten, mit Maleinsäureanhydrid (MSA)-Copolymeren, bei denen die MSA-Gruppen teilweise zu Monoamiden umgesetzt wurden.

Aufgabe der vorliegenden Erfindung ist es daher, ein photopolymerisierbares Gemisch auf der Basis von Carboxylgruppen enthaltenden Bindemitteln zur Verfügung zu stellen, dessen Eigenschaften nach der Belichtung und Entwicklung durch eine thermische Nachbehandlung so verändert werden können, daß Resists mit verbesserten chemischen und physikalischen Eigenschaften, wie z.B. einer erhöhten Hydrolysestabilität und einer größeren mechanischen Beständigkeit gegenüber Ätzsystemen, beim Goldplating oder beim Löten, entstehen. Hierbei sollte das allgemeine Eigenschaftsprofil nicht negativ beeinflußt werden. So sollte eine gute Lagerstabilität, große Verarbeitungs-und Anwendungsbreite und eine exakte Wiedergabe auch feinster Bildelemente gegeben sein.

Diese Aufgabe wird gelöst durch ein lichtempfindliches Gemisch, mit mindestens einer additionspolymerisierbaren, ethylenisch ungesättigten Verbindung, einem Photoinitiator oder einem Photoinitiatorsystem und mindestens einem polymeren Bindemittel, das ein Copolymer mit jeweils einer oder mehreren unterschiedlichen Struktureinheiten A und B und mindestens einer weiteren, carboxylgruppenhaltigen Struktureinheit ist.

Die Erfindung ist dadurch gekennzeichnet, daß
I) 5 bis 50 Gew.% des Copolymeren von einer oder mehreren unterschiedlichen, carboxylgruppenhaltigen Struktureinheiten C1 und/oder C2 gebildet werden.
II) der Anteil an einer oder mehreren unterschiedlichen Struktureinheiten A 5 bis 95 Gew.% beträgt,
III) der Anteil an einer oder mehreren unterschiedlichen Struktureinheiten B 0 bis 50 Gew.% beträgt,
IV) A, B, C1 und C2 die Strukturen 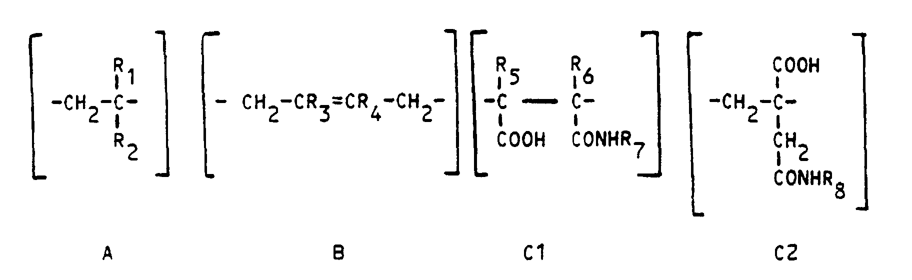 besitzen, worin
   R₁ für H, CH₃, C₂H₅, Phenyl und Alkylphenyl,
   R₂ für H, CH₃, Phenyl, -COOR₉, -CONR₁₀R₁₁ und -CN,
   R₃, R₄, R₅ und R₆ für H und Alkyl und
   R₇, R₈, R₉, R₁₀ und R₁₁ für H, Alkyl und Aryl, welche mit Hydroxy-, Ester-, Halogenid-, Keto-, Ether- und/oder Thioethergruppen substituiert sein können, stehen.

Das erfindungsgemäß, verwendete lichtempfindliche Gemisch enthält polymere Bindemittel, deren Struktur nach der Belichtung und Entwicklung verändert werden kann. Diese Bindemittel bestehen u.a. aus Struktureinheiten mit benachbarten Carboxyl- und Amidgruppen, die nach der bildmäßigen Belichtung und dem Entwikkeln der photopolymerisierbaren Bildaufzeichnungsmaterialien durch eine thermische Nachbehandlung bei 130° bis 200° C in die hydrophoberen Imidgruppen überführt werden können. So bleibt einerseits aufgrund der vor der thermischen Behandlung vorhandenen Carboxylgruppen eine gute Entwickelbarkeit gewährleistet, andererseits werden durch die Überführung dieser Gruppen in Imidgruppen mittels einer thermischen Nachbehandlung die nachteiligen Eigenschaften jener Carboxylgruppen eliminiert.

Überraschend war, daß durch den Einsatz der genannten polymeren Bindemittel in dem erfindungsgemäßen Gemisch solche Resists erhalten werden können, die eine verbesserte chemische und physikalische Beständigkeit gegen Ätzlösungen, beim Goldplating und beim Löten aufweisen, ohne daß die Eigenschaften des Aufzeichnungsmaterials selbst beeinflußt werden. So weisen die erfindungsgemäß hergestellten photopolymerisierbaren Aufzeichnungsmaterialien u.a. eine gute Lagerstabilität bei Raumtemperatur auf und auch bei einer Laminatortemperatur von 120° C sind sie beständig. Dies ist um so erstaunlicher, als durch eine unwesentliche Temperaturerhöhung bei der späteren thermischen Nachbehandlung die Imidgruppen gebildet werden. Hierbei ist es außerdem erforderlich, daß die Temperatur bei der thermischen Nachbehandlung nicht zu hoch liegt und die Behandlungszeit nicht zu lang ist, da sonst das gesamte photopolymerisierbare Aufzeichnungsmaterial unbrauchbar wird.

Aus der DE 25 12 693 ist es zwar bekannt, als polymere Bindemittel Reaktionsprodukte von Styrol-Maleinsäureanhydrid-Copolymeren mit Dialkylaminen einzusetzen, so daß Copolymere mit benachbarten Carboxyl- und Amidfunktionen entstehen, da aber sekundäre Amine eingesetzt werden, erhält man so kein Bindemittel, dessen Eigenschaften nach der Belichtung und Entwicklung durch eine thermische Nachbehandlung geändert werden können. Desweiteren werden in der zitierten Schrift maximal 2/3 der Anhydridgruppen mit Amin umgesetzt, da sonst eine zu große Zahl von Carboxylgruppen eingeführt und so eine gute Haftbindung der lichtempfindlichen Schicht auf einem Metallsubstrat während der Wärmebeschichtung verhindert würde. Es war daher für den Fachmann nicht vorhersehbar, daß die erfindungsgemäßen Aufzeichnungsmaterialien, in denen keine Dicarbonsäureanhydridgruppen vorhanden sind, ohne Schwierigkeiten auf ein Substrat laminiert werden können.

In der EP 00 71 789 werden photopolymerisierbare Resistschichten beschrieben, die eine verbesserte Haftung auf metallischen Substratoberflächen aufweisen. Dies wird erreicht durch die Einführung eines bestimmten Prozentsatzes an Aminofunktionen. Da diese u.a. auch durch die Umsetzung von Maleinsäureanhydrid enthaltenden Bindemitteln mit aliphatischen Diaminen eingeführt werden können, erhält man auch so benachbarte Carboxyl- und Amidfunktionen, wie es in der erfindungsgemäßen Lehre gefordert wird. Diamine sind aber als Reaktionskomponenten im Sinne der erfindungsgemäßen Idee nicht geeignet, da sie eine Verfärbung des Kupfers schon vor der thermischen Nachbehandlung hervorrufen, zudem nicht kontrolliert in die Dicarbonsäureanhydride enthaltenden Bindemittel eingeführt werden können, da Vernetzungen eintreten können, und außerdem zu Rückständen bei der Entwicklung führen, bedingt durch die bessere Haftung, die sie hervorrufen.

In der DD 219 305 wird ein alkalisch entwickelbares, photopolymerisierbares Gemisch beschrieben, das als Bindemittel u.a. das Reaktionsprodukt von Ammoniak und einem Copolymeren, gebildet aus einem ungesättigten Kohlenwasserstoff, einem Maleinsäureanhydrid-Harnstoff-Addukt und Maleinsäureanhydrid, enthalten kann. Aber wie die zuvor erwähnten Diamine führt auch ein harnstoffhaltiges Bindemittel zu Verfärbungen des Kupfers. Zudem zeichnen sich, gemäß der genannten Patentschrift, diese photopolymerisierbaren Gemische durch eine gute Haftung auf Polyesterträgem aus. Da aber ein wesentliches Anwendungsgebiet des erfindungsgemäßen, lichtempfindlichen Gemischs die Herstellung von Schichtübertragungsmaterialien sein soll, sind Harnstoff-Addukte enthaltende Bindemittel hierfür nicht geeignet.

Unter Berücksichtigung des Standes der Technik konnte der Fachmann somit nicht erwarten, daß mit dem erfindungsgemäßen, lichtempfindlichen Gemisch hergestellte Resists verbesserte chemische und physikalische Stabilität aufweisen, ohne daß die Eigenschaften der Aufzeichnungsmaterialien selbst nachteilig beeinflußt werden.

Die erfindungswesentlichen Copolymere des Bindemittels sind aus jeweils einer oder mehreren unterschiedlichen Struktureinheiten A und B und 5 bis 50 Gew.%, bevorzugt 10 bis 30 Gew.%, einer oder mehrerer unterschiedlicher, carboxylgruppenhaltiger Struktureinheiten C1 und/oder C2 aufgebaut. 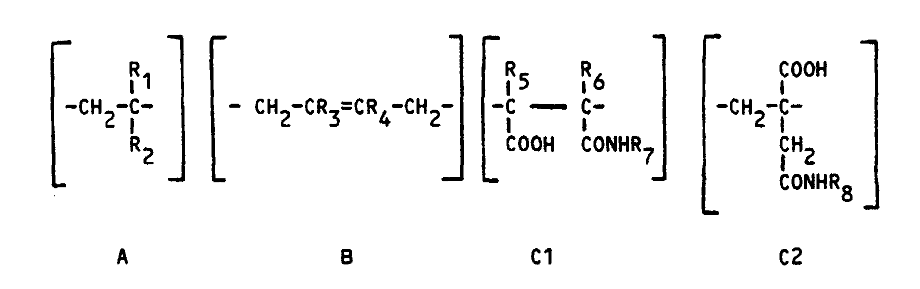
- R₁: steht für H, CH₃, C₂H₅, Phenyl und Alkylphenyl, bevorzugt für H und CH₃
- R₂: für H, CH₃, Phenyl, -COORs, -CONR₁₀R₁₁ und -CN, bevorzugt für Phenyl, COOR₉ und CONR₁₀R₁₁
- R₃, R₄, R₅ und R₆: für H und Alkyl und
- R₇, R₈, R₉, R₁₀ und R₁₁: für H, Alkyl und Aryl, welche mit Hydroxy-, Ester-, Halogenid-, Keto-, Ether- und/oder Thioethergruppen substituiert sein können, bevorzugt für unsubstituierte und hydroxysubstituierte Alkyl- und Arylgruppen.

Der Anteil der Struktureinheiten A sollte 5 bis 95 Gew.%, bevorzugt 10 bis 90 Gew.%, betragen, und von den Struktureinheiten B sollten 0 bis 50 Gew.%, bevorzugt 0 bis 30 Gew.%, vorliegen.

Die erfindungsgemäßen Copolymere können sowohl durch direkte Copolymerisation geeigneter Monomere als auch durch Umsetzung von primären Aminen mit Copolymeren, die durch Copolymerisation eines oder mehrerer ethylenisch ungesättigter Dicarbonsäureanhydride mit einem oder mehreren Comonomeren gebildet werden.
Geeignete ethylenisch ungesättigte Dicarbonsäureanhydride im Sinne der Erfindung sind beispielsweise Maleinsäureanhydrid, Itaconsäureanhydrid und Citraconsäureanhydrid. Der Anteil der ethylenisch ungesättigten Dicarbonsäureanhydride in den Copolymeren beträgt 5 bis 50 Gew.%, bevorzugt 10 bis 30 Gew.%.

Als erfindungsgemäße Amine können primäre aliphatische oder aromatische, ggf. substituierte, Amine verwendet werden. Als Substituenten kommen hierfür folgende funktionelle Gruppen in Frage: Hydroxy-, Ester-, Halogenid-, Keto-, Ether- und/oder Thioethergruppen. Bevorzugt werden Propylamin, Butylamin, Aminopropanol, 4-Methoxyanilin, 4-Aminophenol, Decylamin und/oder Cyclohexylamin verwendet. Als Comonomere, die die Struktureinheiten A und B in dem erfindungswesentlichen Copolymer bilden, eignen sich ungesättigte Kohlenwasserstoffe, wie z.B. Ethylen, Propylen, substituierte Styrole, Butadien und Isopren, und ungesättigte Carbonsäuren und ihre Derivate, wie z.B. (Meth)acrylsäure, (Meth)acrylsäureamide und (Meth)acrylate. Bevorzugt werden Methylmethacrylat, Methylacrylat, Acrylamid, Ethylacrylat, Butylacrylat, Styrol, Isopren und Butadien eingesetzt. Die Copolymere gemäß der Erfindung sollten Molekulargewichte > 10 000, bevorzugt von 30 000 bis 80 000, aufweisen.

Der Anteil des erfindungswesentlichen, benachbarte Carboxyl- und Amidgruppen enthaltenden, Copolymeren am gesamten Bindemittel kann bis zu 100% betragen. Die Menge des gesamten Bindemittels beträgt im allgemeinen 20 bis 90 Gew.% bezogen auf-die-gesamten Bestandteile des Gemisches.

Folgende Bindemittel können z.B. in Kombination mit dem erfindungswesentlichen Bindemittel eingesetzt werden: Polyacrylate, Polymethacrylate. Polystyrol-Polymere und -Copolymere. Polyurethane, Polyester, Polyamide. Bevorzugt werden: Copolymere von Methylmethacrylat, (Meth)acrylsäure oder Maleinsäurehalbester mit Styrol und Copolymere von Methacrylsäure und Alkylmethacrylate.

Geeignete additionspolymerisierbare, ethylenisch ungesättigte Verbindungen, die allein oder in Kombination mit anderen Monomeren verwendet werden können, umfassen tert.-Butylacrylat, Ethylenglykoldiacrylat, 2-Hydroxypropylmethacrylat, Triethylenglykoldiacrylat, Trimethylolpropantriacrylat und -methacrylat, polyoxyethyliertes Trimethylolpropantriacrylat, 1,4-Diisopropenylbenzol, 1,4-Dihydroxybenzoldimethacrylat, Decamethylenglykoldiacrylat, Styrol, Diallylfumarat. Laurylacrylat, Methacrylamid oder Xylylen-bis-acrylamid.

Die Gesamtmenge an Monomeren in dem lichtempfindlichen Gemisch beträgt 10 bis 80 Gew.% bezogen auf die gesamten Bestandteile des Gemischs.

Als Photoinitiatoren oder Photoinitiatorsystem in dem erfindungsgemäßen lichtempfindlichen Gemisch können praktisch alle für diesen Zweck bekannten Verbindungen verwendet werden, als Beispiele seien genannt: 9-Phenylacridin, 9,10-Dimethylbenz(a)phenazin, Benzophenon/Michlers Keton, Hexarylbisimidazol/Mercaptobenzoxazol, Benzildimethylketal, Thioxanthone/Amine. Die Photoinitiatoren werden allgemein in einer Menge von 0,01 bis 10 Gew.% verwendet.

Das lichtempfindliche Gemisch und die daraus hergestellten Bildaufzeichnungsmaterialien können noch weitere Zusätze wie z.B. Farbstoffe, Pigmente, Weichmacher, Haftvermittler, Füllstoffe und/oder Stabilisatoren enthalten.

Bevorzugt wird ein Gemisch gemäß der Erfindung in Form einer lichtempfindlichen Schicht, die sich auf einem Schichtträger befindet, d.h. in Form eines Bildaufzeichnungsmaterials, verwendet. Geeignete Schichtträger sind beispielsweise Papier, metallische Träger, metallkaschierte Träger, Glas, keramische Träger oder Kunststoffolien, z.B. aus Polyethylen, Polycarbonat, Polyamid oder Polyester. Das Aufbringen des lichtempfindlichen Gemischs auf den Schichtträger erfolgt beispielsweise durch Sprühen, Tauchen oder Gießen aus einer Lösung. Die Schichtdicke beträgt gewöhnlich 5 bis 200 µm.

Erfindungsgemäß, wird das lichtempfindliche Gemisch zur Herstellung von Resistmaterialien, vor allem als Schichtübertragungsmaterialien, verwendet. Hierzu wird das lichtempfindliche Gemisch auf einen temporären Schichtträger, vorzugsweise eine Polyesterfolie, aufgebracht und als Deckfolie eine entfernbare Kunststoffolie auflaminiert. Zur Herstellung des Resistbildes wird dann die Deckfolie abgezogen, und die lichtempfindliche Schicht auf einen permanenten Träger, meist eine Kupferoberfläche, auflaminiert. Das Material wird dann bildmäßig belichtet und entwickelt, wobei der temporäre Schichtträger vor oder nach der Belichtung enffernt werden kann. Die Entwicklung erfolgt durch Auswaschen der nicht polymerisierten Bildteile mit geeigneten Lösungen, wie z.B. wäßrig-alkalische Lösungen, organische Lösungsmittel bzw. -gemische oder entsprechende wäßrige Lösungen, die ferner auch oberflächenaktive Substanzen enthalten können.

Nach dem Entwicklungsvorgang wird das Material dann einer thermischen Nachbehandlung unterworfen. Diese kann durch Erhitzen des Materials in einem Elektroofen, Trockenschrank oder mittels einer IR-Lampe durchgeführt werden. Die Temperatur und die Heizdauer hängen von der Zusammensetzung der verwendeten Resistmaterialien ab. Im allgemeinen werden die Materialien 10 bis 60 Minuten auf 130 bis 200° C erhitzt.

Anschließend kann die so hergestellte Resistschicht in üblicher Weise, unter Benutzung der bekannten Galvanisier-, Ätz- oder Lötmethoden, weiterbehandelt werden, ohne daß der Resist abgelöst wird oder Untergalvanisieren auftritt. Die auf dem Träger verbliebene, photopolymerisierte Schicht kann ggf. durch Behandlung mit einer üblichen Entschichtungslösung leicht vollständig entfernt werden. Hierfür eignen sich z.B. stark alkalische, wäßrige Lösungen, die in der Regel bei erhöhter Temperatur zwischen 30° und 90° C in Durchlaufmaschinen oder Tanks angewendet werden oder organische Lösungsmittel wie z.B. Metnylenchlorid.

Obwohl die Erfindung in der vorstehenden Beschreibung bevorzugt in ihrer Anwendung als Schichtübertragungsmaterial für Photoresists beschrieben wurde, ist sie nicht auf diese Anwendung beschränkt. Sie ist in allen Fällen anwendbar, in denen es darauf ankommt. bildmäßige Schablonen bzw. Reliefmaterialien von besonders hoher chemischer und physikalischer Beständigkeit zu erzeugen.

Die nachfolgenden Beispiele sollen die Erfindung erläutern.

### Beispiel 1

### A) Herstellung des amid- und carboxylgruppenhaltigen Copolymeren

20 g eines Copolymeren aus Methylmethacrylat/Styrol/Maleinsäureanhydrid (SZ =̂115 = 20,43 mMol Maleinsäure/20 g Polymer) wurden in 100 ml Methylenchlorid bei Raumtemperatur gelöst. 1,3 g (=̂ 22,47 mMol) Propylamin in 100 ml Methylenchlorid wurden zu der Polymerlösung gegeben. Es trat Erwärmung auf 25° C ein. Nach 4stündigem Rühren bei Raumtemperatur wurde das Polymer durch Eingießen der Lösung in 1 I Petrolether (40-60° C) ausgefällt, abfiltriert und im Vakuum getrocknet. Das IR-Spektrum zeigte keine Carbonylschwingungen bei 1860 cm⁻¹ und 1780 cm⁻¹ mehr.

### B) Herstellung eines Trockenresistfilms

Es wurde folgende Gießlösung hergestellt

| | |
|---|---|
| 44 ml | Methylenchlorid |
| 6,7 ml | Methanol |
| 9,14 g | des unter A) hergestellten Polymeren |
| 6,10 g | eines Copolymeren aus Methylmethacrylat/Ethylacrylat/Acrylsäure, |
| | SZ = 80, MG = 30 000, Tg = 50° C |
| 5,75 g | 3-(4-Hydroxybenzoyloxy-)-2-hydroxy-propylmethacrylat |
| 2,96 g | Trimethylolpropantriacrylat |
| 4,23 g | polyoxyethyliertes Trimethylolpropantriacrylat, MG = 1162 20 Mol |
| | Ethylenoxid |
| 2,01 g | Benzildimethylketal |
| 0,17 g | Diethanolamin |
| 3,59 g | Kieselsäure: SiO₂-Gehalt > 99,8%, |
| | Oberfläche nach BET 200 m²/g, Primärteilchengröße 12 mm |
| 28 mg | Nilblau (C.l. 51180) |

Die Gießlösung wurde auf eine 25 µm dicke Polyesterfolie aufgebracht, so daß eine Trockenschichtdicke von 42 g/m² erzielt wurde.

### C) Verwendung des unter B) hergestellten Trockenresistfilmes

Der unter B) hergestellte Trockenresistfilm wurde unter üblichen Bedingungen auf mit 35 µm Kupferauflage kaschiertes Basismaterial bei 110° C Walzentemperatur mit 2,0 m/min auflaminiert, durch eine Galvanovorlage mit 50 mj/cm² belichtet und mit einer 1%igen Na₂CO₃-Lösung bei 30° C in einem Durchlaufprozessor entwickelt. Die Klärzeit betrug 25 sec. Eine so entwickelte Platte wurde ohne thermische Behandlung in einem handelsüblichen MRC-Goldbad bei einer Stromstärke von 1A/dm² behandelt Bereits nach 6 min, entsprechend einem Galvanoauftrag < 2 µm Gold, wurde ein Ablösen des Resists und starkes Untergalvanisieren beobachtet. Wurde eine wie oben entwickelte Platte jedoch 5 min bei 150° C thermisch behandelt, so wurde nach 18 min ein Galvanoauftrag > 6 µm Gold erreicht, ohne daß der Resist abgelöst wurde oder Untergalvanisieren auftrat.
Beide Platten konnten anschließend in 3%iger KOH bei 50° C einwandfrei und sauber entschichtet werden:

| | Entschichtungszeit |
|---|---|
| a) ohne thermische Behandlung | 25 sec |
| b) mit thermischer Behandlung | 35 sec |

### Beispiel 2

### A) Herstellung des Polymeren

20 g (=̂ 20,43 mMol Maleinsäure) des Copolymeren aus Beispiel 1A wurden in 300 ml Methylenchlorid bei Raumtemperatur gelöst. 1,53 g (=̂ 20,4 mMol) 1-Amino-2-propanol wurden in 50 ml Methylenchlorid gelöst und unter Rühren zu der Polymerlösung getropft. Es trat Erwärmung auf 27° C ein. Nach 4stündiger Reaktionszeit wurde das Polymer durch Eingießen in 2,5 1 Petrolether (40-60° C) ausgefällt, abfiltriert und im Vakuum getrocknet. Im IR-Spektrum wurden keine Carbonylschwingungen bei 1860 cm⁻¹ und 1780 cm⁻¹ mehr gefunden.

### B) Herstellung eines Trockenresistfilms

Es wurde folgende Gießlösung hergestellt:

| | |
|---|---|
| 44 ml | Methylenchlorid |
| 6,7 ml | Methanol |
| 7,61 g | des unter A) hergestellten Polymeren |
| 7,61 g | eines Copolymeren aus Methylmethacrylat/Ethylacrylat/Acrylsäure, |
| | SZ = 80, MG = 30 000, Tg = 50° C |
| 5,75 g | 3-(4-Hydroxybenzoyloxy-)-2-hydroxy-propylmethacrylat |
| 7,19 g | Trimethylolpropantriacrylat |
| 2,01 g | Benzildimethylketal |
| 0,17 g | Diethanolamin |
| 3,33 g | Kieselsäure: SiO₂-Gehalt > 99,8%, |
| | Oberfläche nach BET 200 m²/g, Primärteilchengröße 12 mm |
| 28 mg | Nilblau (C.l. 51180) |

Die Herstellung des Trockenresistfilms erfolgte wie in Beispiel 1B.

### C) Verwendung des unter B) hergestellten Trockenresistfilmes

Der Trockenresistfilm wurde wie in Beispiel 1C auf ein mit Kupfer kaschiertes Basismaterial auflaminiert, belichtet und entwickelt. Eine so entwickelte Platte wurde ohne thermische Behandlung in dem in Beispiel 1C beschriebenen Goldbad behandelt. Es wurde bereits nach 5 min( entsprechenden < 2 µm Goldauftrag) ein Ablösen des Resists beobachtet.
Nach einer thermischen Behandlung von 10 min bei 150° C konnten dagegen nach 22 min > 8 µm Gold abgeschieden werden, ohne daß der Resist abgelöst wurde oder Untergalvanisieren eintrat. Beide Platten konnten anschließend in 3%iger KOH bei 50° C einwandfrei und sauber entschichtet werden:

| | Entschichtungszeit |
|---|---|
| a) ohne thermische Behandlung | 30 sec |
| b) mit thermischer Behandlung | 40 sec |

### Beispiel 3

### A) Herstellung des Polymeren

100 g (=̂ 0,102 Mol Maleinsäure) des Copolymeren aus Beispiel 1A wurden in 500 ml Tetrahydrofuran bei Raumtemperatur gelöst. 12 g (=̂ 0,11 Mol) p-Aminophenol wurden in 100 ml Tetrahydrofuran gelöst und zu der Polymerlösung gegeben. Es wurde auf 40° C erwärmt und 4 h bei dieser Temperatur gerührt. Das Polymer wurde durch Eingießen der Lösung in 3 l Petrolether (40-60° C) ausgefällt, abfiltriert und im Vakuum getrocknet. Im IR-Spektrum wurden keine Carbonylschwingungen bei 1860 cm⁻¹ und 1780 cm⁻¹ mehr gefunden.

### B) Herstellung des Trockenresistfilms

Es wurde folgende Gießlösung hergestellt:

| | |
|---|---|
| 44 ml | Methylenchlorid |
| 6,7 ml | Methanol |
| 7,24 g | des unter A) hergestellten Polymeren |
| 7,24 g | eines Copolymeren aus Methylmethacrylat/Ethylacrylat/Acrylsäure, |
| | SZ = 80, MG = 30 000, Tg = 50° C |
| 6,19 g | 3-(4-Hydroxybenzoyloxy-)-2-hydroxy-propylmethacrylat |
| 7,45 g | Trimethylolpropantriacrylat |
| 2,07 g | Benzildimethylketal |
| 0,17 g | Hexamethylendiamin |
| 5,4 g | Kieselsäure: SiO₂-Gehalt > 99,8%, |
| | Oberfläche nach BET 200 m²/g, Primärteilchengröße 12 mm |
| 28 mg | Nilblau (C.l. 51180) |

Der Trockenresistfilm wurde wie in Beispiel 1B hergestellt.

### C) Verbindungen des unter B) hergestellten Trockenresistfilmes

Der Trockenresistfilm wurde wie in Beispiel 1C verarbeitet. Eine so entwickelte Platte wurde ohne thermische Behandlung in dem in Beispiel 1C beschriebenen Goldbad behandelt. Es wurde bereits nach 6 min (entsprechend < 2 µm Goldauftrag) ein Ablösen des Resists beobachtet. Nach einer thermischen Behandlung von 10 min bei 150° C wurden nach 18 min > 6 µm Gold abgeschieden, ohne daß der Resist abgelöst wurde oder Untergalvanisieren eintrat.
Beide Platten konnten in 3%iger KOH-Lösung bei 50° C einwandfrei und sauber entschichtet werden:

| | Entschichtungszeit |
|---|---|
| a) ohne thermische Behandlung | 25 sec |
| b) mit thermischer Behandlung | 35 sec |

### Beispiel 4

Es wurde folgende Gießlösung hergestellt: In

| | |
|---|---|
| 44 ml | Methylenchlorid und |
| 6,7 ml | Methanol wurden |
| 15,3 g | eines Copolymeren aus Methylmethacrylat/Butylacrylat/Itaconsäureanhydrid, |
| | (40/44/16), SZ = 160, MG = 36 000, Tg = 29° C gelöst. |

Es wurden 1,64 g iso-Propanolamin zugegeben und 1 h gerührt.
Dieser Lösung wurde weiterhin zugesetzt:

| | |
|---|---|
| 5 g | 3-(4-Hydroxybenzoyloxy-)-2-hydroxy-propylmethacrylat |
| 2,93 g | Trimethylpropantriacrylat |
| 4,88 g | polyoxyethyliertes Trimethylolpropantriacrylat, MG = 1162 20 Mol Ethylenoxid |
| 2 g | Benzildimethylketal |
| 0,17 g | Diethanolamin |
| 3,28 g | Kieselsäure: SiO₂-Gehalt > 99,8%, Oberfläche nach BET 200 m2/g, Primärteilchengröße 12 mm |
| 28 mg | Nilblau (C.l. 51180) |

Aus dieser Gießlösung wurde wie in Beispiel 1 ein Trockenresistfilm mit 42 g/m² Auftragsmasse hergestellt. Der Trockenresistfilm wurde wie in Beispiel 1C laminiert, mit 50 mj/cm² belichtet und in 1%iger Na₂CO₃-Lösung bei 30° C entwickelt. Die Klärzeit betrug 20 sec.
Eine so entwickelte Platte wurde ohne thermische Behandlung in dem in Beispiel 1C beschriebenen Goldbad behandelt. Es wurde bereits nach 6 min (entsprechend < 2 µm Goldauftrag) ein Ablösen des Resists beobachtet. Nach einer thermischen Behandlung von 10 min bei 150° C wurden nach 20 min > 7 µm Gold abgeschieden, ohne daß der Resist abgelöst wurde oder Untergalvanisieren eintrat.
Beide Platten konnten in 3%iger KOH-Lösung bei 55° C einwandfrei und sauber entschichtet werden:

| | Entschichtungszeit |
|---|---|
| a) ohne thermische Behandlung | 30 sec |
| b) mit thermischer Behandlung | 50 sec |

### Beispiel 5

Es wurde folgende Gießlösung hergestellt:

| | |
|---|---|
| 44 ml | Methylenchlorid |
| 6,7 ml | Methanol |
| 21,0 g | eines Copolymeren aus Methylmethacrylat/Styrol/Maleinsäureanhydrid, |
| | SZ = 115, MG = 30 000 |
| 1,24 g | Isopropylamin |

Diese Lösung wurde 1 h gerührt. Anschließend wurde weiter zugegeben:

| | |
|---|---|
| 10,09 g | polyoxyethyliertes Trimethylolpropantriacrylat, MG = 1162 20 Mol Ethylenoxid |
| 2,1 g | Polypropylenglykol-420-diacrylat |
| 1,4 g | Benzophenon |
| 0,05 g | Ethyl Michler's Keton |
| 40 mg | Nilblau (C.l. 51180) |

Die Gießlösung wurde auf eine 25 µm dicke Polyesterunterlage mit einer Trockenschichtdicke von 42 g/m² aufgebracht.
Der Trockenresistfilm wurde unter üblichen Bedingungen auf mit 35 µm Kupfer kaschiertes Basismaterial bei 110° C Walzentemperatur mit 2,0 m/min auflaminiert, mit 60 mj/cm² durch eine Galvanovorlage belichtet und in einem handelsüblichen Processor mit 1,1,1-Trichlorethan entwickelt.
Der Trockenresistfilm wurde wie in Beispiel 1C verarbeitet. Eine so entwickelte Platte wurde ohne thermische Behandlung in dem in Beispiel 1C beschriebenen Goldbad behandelt. Es wurde bereits nach 8 min (entsprechend < 3 µm Goldauftrag) ein Ablösen des Resists beobachtet. Nach einer thermischen Behandlung von 10 min bei 150° C wurden nach 22 min > 8 µm Gold abgeschieden, ohne daß der Resist abgelöst wurde oder Untergalvanisieren eintrat.
Beide Platten konnten in Methylenchlorid/Methanol (95/5) einwandfrei und sauber entschichtet werden.

### Beispiel 6

Es wurden folgende Gießlösungen hergestellt:

| | A | B |
|---|---|---|
| Methylenchlorid | 216 g | 216 g |
| Methanol | 11 g | 11 g |
| Copolymere aus Beispiel 1A | 50 g g | -- g |
| Copolymer aus Ethylmethacrylat/Ethylacrylat/Methacrylsäure, | -- g | 50 g |
| (29/60/11) SZ = 80, Tg = 35° C | | |
| Pentaerythritoltetraacrylat | 40 g | 40 g |
| Benzophenon | 4 g | 4 g |
| Ethyl-Michler's Keton | 0,2 g | 0,2 g |
| 3-Mercapto-1,2,4-triazol | 0,2 g | 0,2 g |
| Poly(oxypropylen)diamin | 10 g | 10 g |
| 1-(1-Isocyanato-1-methylethyl)-3-(1-methylethenyl)-benzol | 7,5 g | 7,5 g |

Die Gießlösungen wurden auf eine 25 µm dicke Polyesterfolie aufgebracht, so daß eine Trockenschichtdicke von 50 µm erreicht wurde.
Die Trockenresistfilme A und B wurden auf ein COMB-Leiterzugmuster entsprechend IPC-SM 840A auflaminiert, die zuvor mit Tripropylenglygoldiacrylat besprüht worden waren.
Beide Platten wurden mit jeweils 80 mj/cm² durch die entsprechende Testvorlage belichtet und mit einer 1%igen Na₂CO₃-Lösung bei 30° C entwickelt.

Beide Platten wurden nach der Entwicklung jeweils 1h bei 150° C behandelt und anschließend mit 4 J/cm² belichtet. Die Messung der Feuchtigkeits- und Isolationseigenschaften wurde entsprechend den IPC Class III Testbedingungen durchgeführt. Es wurden folgende Widerstände gemessen:

| | |
|---|---|
| Formulierung A | 1 x 10⁹ Ω |
| Formulierung B | 6 x 10⁷ Ω |

## Patentansprüche

1. Verwendung eines lichtempfindlichen Gemischs mit
a) mindestens einer additionspolymerisierbaren, ethylenisch ungesättigten Verbindung,
b) einem Photoinitiator oder einem Photoinitiatorsystem und
c) mindestens einem polymeren Bindemittel, das ein Copolymer mit jeweils einer oder mehreren unterschiedlichen Struktureinheiten A und B und mindestens einer weiteren carboxylgruppenhaltigen Struktureinheit ist,
in Schichtübertragungsmaterialien zur Herstellung von Photoresistschichten und Lötstopmasken,
dadurch gekennzeichnet, daß
I) 5 bis 50 Gew.-% des Copolymeren von einer oder mehreren unterschiedlichen, carboxylgruppenhaltigen Struktureinheiten C1 und/oder C2 gebildet werden,
II) der Anteil an einer oder mehreren unterschiedlichen Struktureinheiten A 5 bis 95 Gew.-% beträgt,
III) der Anteil an einer oder mehreren unterschiedlichen Struktureinheiten B 0 bis 50 Gew.-% beträgt,
IV) A, B, C1 und C2 die Strukturen 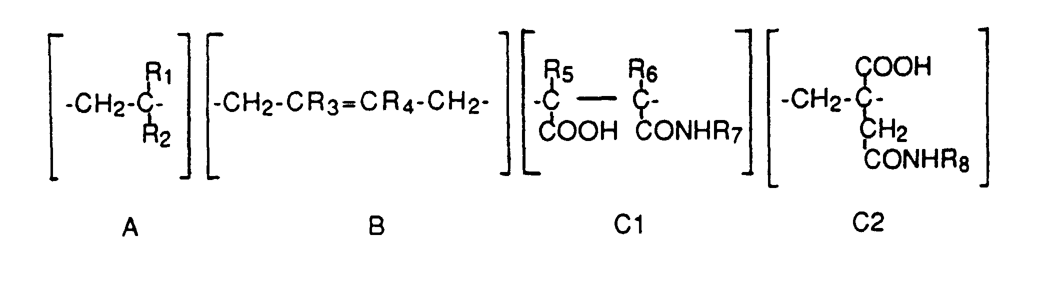 besitzen, worin
R₁ für H, CH₃, C₂H₅, Phenyl und Alkylphenyl,
R₂ für H, CH₃, Phenyl, -COOR₉, -CONR₁₀R₁₁ und -CN,
R₃, R₄, R₅ und R₆ für H und Alkyl und
R₇, R₈, R₉, R₁₀ und R₁₁ für H, Alkyl und Aryl, welche mit Hydroxy-, Ester-, Halogenid-, Keto-, Ether- und/oder Thioethergruppen substituiert sein können, stehen und die Photoresistschichten und Lötstopmasken nach der Entwicklung einer thermischen Nachbehandlung bei 130 bis 200 °C unterzogen werden.

2. Verwendung nach Anspruch 1,
dadurch gekennzeichnet, daß
das genannte Copolymer als alleiniges Bindemittel vorliegt.

3. Verwendung nach Anspruch 1 und 2,
dadurch gekennzeichnet, daß
das genannte Copolymer das Reaktionsprodukt eines Copolymeren, gebildet aus einem oder mehreren ethylenisch ungesättigten Dicarbonsäureanhydrid(en) und einer oder mehreren ethylenisch ungesättigten Verbindung(en), mit primären Aminen ist.

4. Verwendung nach Anspruch 3,
dadurch gekennzeichnet, daß
als ethylenisch ungesättigte Dicarbonsäureanhydride Maleinsäureanhydrid, Itaconsäureanhydrid, und/oder Citraconsäureanhydrid eingesetzt werden.

5. Verwendung nach Anspruch 3 und 4,
dadurch gekennzeichnet, daß
als Amine unsubstituierte und/oder hydroxysubstituierte Alkyl- und/oder Arylamine verwendet werden.

6. Verwendung nach Anspruch 3 bis 5,
dadurch gekennzeichnet, daß
als Comonomere Styrol, Isopren, Butadien, (Meth)acrylsäure, (Meth)acrylamide und/oder (Meth)acrylate eingesetzt werden.

7. Verwendung nach Anspruch 1 bis 6,
dadurch gekennzeichnet, daß
das Gemisch in Form einer festen übertragbaren Schicht auf einem Schichtträger aus Kunststoffolie vorliegt und ggf. mit einer oder mehreren Deckschichten versehen ist.

8. Verwendung des in den Ansprüchen 1 bis 7 genannten lichtempfindlichen Gemischs in einem Verfahren zur Bildaufzeichnung, umfassend die bildmäßige Belichtung einer aus dem lichtempfindlichen Gemisch bestehenden Schicht, die anschließende Entwicklung durch Auswaschen der unbelichteten Bereiche und eine thermische Nachbehandlung bei 130 bis 200 °C.

## Claims

1. Use of a lightsensitive composition comprising
a) at least one addition-polymerizable, ethylenically unsaturated compound,
b) a photoinitiator or a photoinitiator system and
c) at least one copolymeric binder containing one or more structural units A and B and at least one additional structural unit containing carboxyl groups
in layer transfer materials for the production of photoresist layers and solder masks,
characterized in that
I) 5 to 50 percent by weight of the copolymer is formed from one or more different structural units C1, C2 or combinations thereof containing carboxyl groups,
II) the proportion of one or more different structural units A is 5 to 95 percent by weight,
III) the proportion of one or more different structural units B is 0 to 50 percent by weight and
IV) A, B, C1 and C2 have the structures 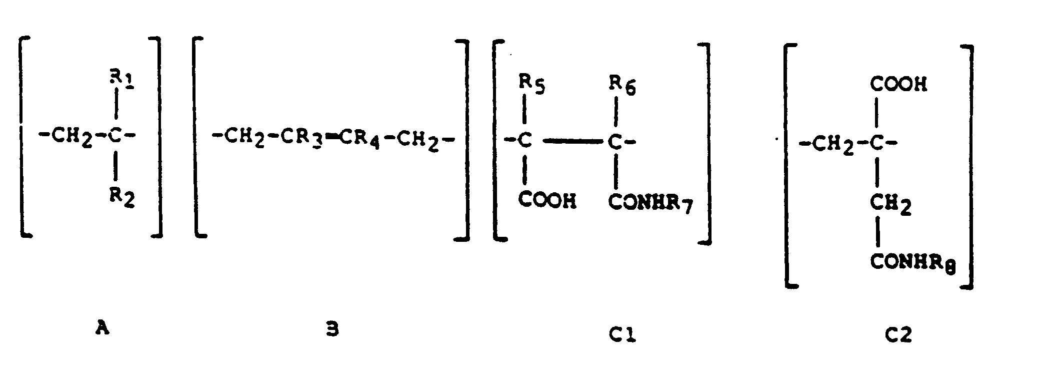 in which
R₁ = H, CH₃, C₂H₅, phenyl and alkylphenyl
R₂ = H, CH₃, phenyl, -COOR₉, -CONR₁₀R₁₁ and -CN,
R₃, R₄, R₅, and R₆ = H and alkyl and
R₇, R₈, R₉, R₁₀ and R₁₁ = H, alkyl and aryl, which is unsubstituted or substituted with hydroxy, ester, halogen, keto, ether or thioether groups, and the photoresist layers and solder masks are subject to a thermal posttreatment at 130 to 200° C after the development.

2. Use according to claim 1 characterized in that the specified copolymer is present as the only binder.

3. Use according to claim 1 or 2 characterized in that the specified copolymer is the reaction product of a copolymer formed from one or more ethylenically unsaturated dicarboxylic acid anhydrides and one or more ethylenically unsaturated compounds with primary amine.

4. Use according to claim 3 characterized in that maleic acid anhydride, itaconic acid anhydride or citraconic acid anhydride is used as an ethylenically unsaturated dicarboxylic acid anhydride.

5. Use according to claim 3 or 4 characterized in that unsubstituted or hydroxy substituted alkyl or aryl amine is used.

6. Use according to claims 3 to 5 characterized in that styrene, isoprene, butadiene, (meth)acrylic acid, (meth)acrylamides and/or (meth)acrylates are used as comonomers.

7. Use according to claims 1 to 6 characterized in that the composition is present in the form of a solid, transferable layer on a support of synthetic resin film and optionally one or more cover layers are provided.

8. Use of the lightsensitive composition mentioned in claims 1 to 7 in an image recording process comprising imagewise exposure of a layer consisting of a photopolymerizable composition according to the invention, following development by washing-off of the unexposed areas, and thermal posttreatment at 130° C to 200° C.

## Revendications

1. Utilisation d'une composition photosensible comprenant
a) au moins un dérivé éthyléniquement insaturé polymérisable par addition,
b) un photoinitiateur ou un système photoinitiateur et
c) au moins un liant copolymère avec un ou plusieurs éléments de structure A et B et au moins un élément de structure contenant des groupes carboxyls
comme matériau de transfert de couche pour la production des couches photorésists et des masques à soudure,
caractérisée en ce que
I) 5 à 50% en poids de copolymère sont formé par un ou plusieurs éléments de structure C1, C2 ou des combinaisons de ces éléments,
II) la proportion d'un ou plusieurs éléments de structure A est 5 à 95 % en poids,
III) la proportion d'un ou plusieurs éléments de structure B est 0 à 50% en poids et
IV) A, B, C1 et C2 ont les structures 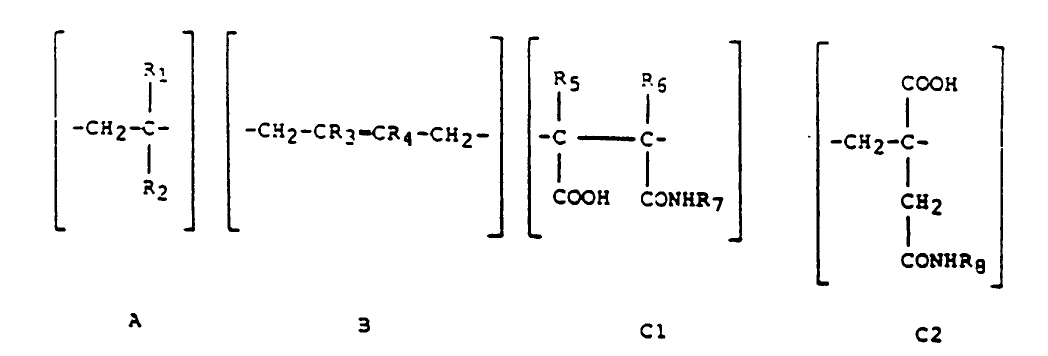 dans lesquelles
R₁ = H, CH₃,C₂H₅, phényle et phényle substitué par une groupe alkyle
R₂ = H,CH₃, phényle, -COOR₉, -CONR₁₀R₁₁ et -CN.
R₃, R₄, R₅, et R₆ = H et alkyle et
R₇, R₈, R₉, R₁₀ et R₁₁ = H, alkyle et aryle qui peuvent être substitué par des groupes hydroxyle, ester, halogénure, cétone, éther et/ou thioéther, et, après le développement, les couches photorésists et les masques à soudure sont soumis à un traitement ultérieure thermique de 130 à 200°C.

2. Utilisation selon la revendication 1, caractérisé en ce que le copolymère décrit est le seul liant.

3. Utilisation selon la revendication 1 ou 2 caractérisé en ce que le copolymère décrit est le produit de la réaction d'un copolymère formé par un ou plusieurs anhydrides dicarboxyliques insaturés et un ou plusieurs dérivés éthyléniquement insaturés avec des amines primaires.

4. Utilisation selon la revendication 3, caractérisé en ce qu'on utilise comme les anhydrides dicarboxyliques éthyléniquement insaturés l'anhydride maléique, itaconique et/ou citraconique.

5. Utilisation selon la revendication 3 ou 4, caractérisé en ce qu'on utilise comme des amines les amines d'alkyle et/ou d'aryle qui sont non-substitués ou substitués par des groupes hydroxyle.

6. Utilisation selon une des revendications 3 à 5 caractérisé en ce qu'on utilise comme des comonomères le styrène, le isoprène, le butadiène, l'acide acrylique, l'acide méthacrylique, l'acrylamide, le méthacrylamide et/ou les esters acryliques ou méthacryliques.

7. Utilisation selon une des revendications 1 à 6 caractérisé en que la composition photosensible est utilisée comme une couche solide et transférable sur un support de pellicule à résine synthétique et à l'occasion avec une ou plusieurs couches de couverture.

8. Utilisation de la composition mentionnée dans une des revendications 1 à 7 dans un procédé d'enregistrement d'une image comprenant d'exposition artistique d'une couche à une composition photopolymérisable selon l'invention, de développement par dépouillement des régions pas exposées et de traitement ultérieur thermique de 130° C à 200° C.
